# EUROPÄISCHE PATENTANMELDUNG

(11) **EP 4 843 931 A1**
(43) Veröffentlichungstag der Anmeldung: **25.11.2026**
(21) Anmeldenummer: 26179236.0
(22) Anmeldetag: 18.05.2026
(51) Int. Cl.: B65G 47/00, B67C 3/00, C23C 14/04, C23C 14/50, C23C 16/04, C23C 16/54, C23C 16/458

(54) **VERFAHREN ZUM BESCHICHTEN VON BEHÄLTERN UND BESCHICHTUNGSANLAGE**

(30) Priorität: 20.05.2025 DE 102025119507
(71) Anmelder: KHS GmbH, 44143 Dortmund (DE)
(72) Erfinder: Klatt, Dieter, 44143 Dortmund (DE)
(74) Vertreter: Andrejewski - Honke Patent- und Rechtsanwälte Partnerschaft mbB

(57) **Zusammenfassung**

Die Erfindung betrifft ein Verfahren zum Beschichten von Behältern (1), insbesondere von Getränkebehältern, aus Kunststoff, wobei die Behälter (1) in einem Sollzustand in einer geschlossenen Behälterreihe entlang eines Transportpfades während dem Produktionsbetrieb einem Beschichtungsrad (2) über eine Einlaufsternanordnung (3) zugeführt und anschließend zumindest zwei Behälter (1) während einer Rotation des Beschichtungsrades (2) gemeinsam in einer Beschichtungseinheit (5) beschichtet werden und wobei die beschichteten Behälter (1a) über die Auslaufsternanordnung (4) abgeführt werden. Erfindungsgemäß wird zumindest eine unbesetzte Position (7) in der Behälterreihe vor und/oder in der Einlaufsternanordnung (3) erfasst und jeweils ein beschichteter Behälter (1a) an der unbesetzten Position (7) zugeführt.

## Beschreibung

Die vorliegende Erfindung betrifft ein Verfahren zum Beschichten von Behältern, insbesondere von Getränkebehältern, aus Kunststoff, wobei die Behälter in einem Sollzustand in einer geschlossenen Behälterreihe entlang eines Transportpfades während dem Produktionsbetrieb einem Beschichtungsrad über eine Einlaufsternanordnung zugeführt und anschließend zumindest zwei Behälter während einer Rotation des Beschichtungsrades gemeinsam in einer Beschichtungseinheit des Beschichtungsrades beschichtet werden und wobei die beschichteten Behälter über die Auslaufsternanordnung abgeführt werden.

In der Getränkeindustrie oder auch für andere flüssige oder pastöse Produkte werden in der Praxis Kunststoffbehälter und insbesondere Kunststoffflaschen eingesetzt. Weit verbreitet sind Flaschen aus PET (Polyethylenterephthalat) welche sich durch gute Funktionseigenschaften einschließlich einer guten Recyclingfähigkeit auszeichnet.

Obwohl PET im Vergleich zu vielen anderen Kunststoffen bereits gute Barriereeigenschaften aufweist, besteht bei empfindlichen Produkten oder besonders hohen Qualitätsanforderungen das Bedürfnis, die Barriereeigenschaften weiter zu verbessern. Hierzu ist es bekannt, die Behälterwand mit einer inneren Barriereschicht zu versehen. Hierzu können dünne Schichten aus Kohlenwasserstoffverbindungen oder dünne quarzglasähnliche Schichten insbesondere auf der Basis von SiOₓ vorgesehen sein. (s. "Blasformen von Kunststoffkörpern", zweite, aktualisierte Auflage 2022, Michael Thielen, Klaus Hartwig, Peter Gust, ISBN 978-3-446-45552-8, Seiten 211 bis 213).

Entsprechende Vorrichtungen und Verfahren sind auch in der EP 3 433 395 B1, der DE 102 25 609 A1 und der WO 03/100120 A2 beschrieben.

Die Abscheidung zumindest einer dünnen Schicht erfolgt durch einen Plasmaverfahren, wobei dazu häufig unterschiedliche Druckstufen vorgesehen sein können. Insbesondere kann auch eine oberflächliche Reinigung oder Aktivierung vorgesehen sein, bevor die Beschichtung aufgebracht wird. Auch die Erzeugung mehrerer Schichten in unmittelbar aufeinander folgenden Schritten ist dabei möglich. Dabei ist auch zu berücksichtigen, dass als Prozessfluide eingeleitete Gase und/oder trotz einer Druckreduzierung verbleibende Luft durch den Plasmaprozess aktiviert werden können, wodurch reaktive Gase bzw. reaktive Gasbestandteile gebildet werden. Als reaktive Bestandteile können insbesondere Sauerstoff, Ozon und Sauerstoffionen vorhanden sein.

Um eine Massenfertigung zu ermöglichen, werden Beschichtungsanlagen eingesetzt, die um den Umfang eines Trägerrades eine Vielzahl von Beschichtungseinheiten aufweisen. Die Beschichtungseinheiten können dabei für die Aufnahme zumindest von zwei oder mehrerer Behälter eingerichtet sein, wobei die gesamte Beschichtung während der Rotation der Beschichtungseinheiten zwischen einer Zuführposition und einer Abführposition der als Getränkeflaschen ausgestalteten Behälter kontinuierlich erfolgt. Um für den Beschichtungsprozess unterschiedliche Druckniveaus in einem Vakuumbereich und/oder unterschiedliche Fluide bereitzustellen und abzuführen, weisen die Beschichtungseinheiten jeweils eine Ventilanordnung mit mehreren Ventilen auf, die an entsprechende Druckreservoirs bzw. Fluidreservoirs angeschlossen sind.

Die Funktion einer bekannten Behälterschichtungsanlage ist auch in dem Video "KHS InnoPET Plasmax 12D", https://voutu.be/tYbr6B5CHhk dargestellt.

Für den Beschichtungsprozess ist es von besonderer Bedeutung, dass während des Beschichtungsschrittes der Behälterinnenraum evakuiert wird und weitestgehend frei von Luftbestandteilen ist. Im Rahmen der Erfindung ist mit einem Vakuum gemeint, dass der Druck im Behälterinnenraum zwischen 0,05 mbar und 5 mbar, bevorzugt zwischen 0,2 und 1 mbar, liegt.

Zur Aufrechterhaltung des Vakuums ist es jedoch zwingend erforderlich, dass sämtliche Positionen innerhalb der Beschichtungseinheit mit einem Behälter besetzt sind, da nur bei eingesetzten Behältern eine wirksame Abdichtung innerhalb einer von der Beschichtungseinheit gebildeten Beschichtungskammer gegenüber einer Ventileinrichtung gewährleistet werden kann.

Dies ist jedoch gerade dann problematisch, wenn die Behälter innerhalb der Beschichtungsanlage in einer geschlossenen Behälterreihe geführt werden. Mit einer geschlossenen Behälterreihe ist in diesem Zusammenhang gemeint, dass die Behälter innerhalb der Beschichtungsanlage entlang des Transportpfades an definierten zueinander beabstandeten Positionen angeordnet sind. Diese Positionen werden im Wesentlichen durch die Behälteraufnahmen der Einlaufsternanordnung, des Beschichtungsrades und der Auslaufsternanordnung bestimmt. Eine solche Ausgestaltung wird gemeinhin auch als verblockte Bauweise bezeichnet, da die Behälter in einer festgelegten Teilung zueinander angeordnet sind und an vorbestimmten Positionen zwingend von einer Anlagenkomponente an eine andere Anlagenkomponente weitergereicht werden. Dies hat jedoch auch zur Folge, dass im Falle einzelner unbesetzter Positionen in der Behälterreihe diese nicht ohne Weiteres aufgefüllt werden können. Folglich wird diese unbesetzte Position entlang des gesamten Transportpfades weitergereicht und gelangt somit von der Einlaufsternanordnung in das Beschichtungsrad und von dort in die Auslaufsternanordnung. Hierbei ist zu beachten, dass die Behälter üblicherweise von der Blasanlage bzw. einer Streckblasanlage entweder unmittelbar oder über eine Transfersternanordnung an die Beschichtungsanlage übergeben werden. Fehler im Blasprozess können daher dazu führen, dass einzelne Positionen in der Behälterreihe unbesetzt bleiben.

Um dennoch in geeignetem Maße eine Beschichtung innerhalb des Beschichtungsrades zu ermöglichen, ist es üblich, die Beschichtungseinheiten, welche die unbesetzte Position der Behälterreihe aufweisen, vollständig von dem Beschichtungsbetrieb zu trennen, sodass diese Beschichtungseinheit erst dann wieder in den Produktionsbetrieb übergehen kann, sobald in einem neuen Durchlauf sämtliche Positionen innerhalb der entsprechenden Beschichtungseinheit besetzt sind Dies hat jedoch zur Folge, dass einzelne Behälter nicht beschichtet werden können und je nach Ausgestaltung auch nicht ohne Weiteres dem Produktionsprozess erneut zugeführt werden können.

Vor diesem Hintergrund liegt der Erfindung die Aufgabe zugrunde, ein Verfahren anzugeben, welches sich durch einen verbesserten Produktionsbetrieb mit geringerem Ausschuss an Behältern auszeichnet.

Gegenstand der Lösung dieser Aufgabe ist ein Verfahren gemäß Patentanspruch 1. Demnach ist erfindungsgemäß vorgesehen, dass zumindest eine unbesetzte Position in der Behälterreihe vor und/oder in der Einlaufsternanordnung erfasst wird und wobei jeweils ein beschichteter Behälter der unbesetzten Position zugeführt wird.

Entsprechend wird ermittelt, ob ausgehend von dem Sollzustand einzelne Positionen im Ist-Zustand nicht besetzt sind. Diese unbesetzten Positionen werden dann mit bereits beschichteten Behältern aufgefüllt, sodass ein Abschalten der gesamten Beschichtungseinheit verhindert werden kann. In Konsequenz werden dann die bereits beschichteten Behälter ein zweites Mal beschichtet, wobei es in der Regel aus lebensmitteltechnischen Gründen zwingend ist, dass die doppelt beschichteten Behälter separat von den anderen beschichteten Behältern abgeführt und vernichtet werden. Alternativ ist es auch denkbar, dass ausschließlich der bereits beschichtete Behälter während des zweiten Durchlaufes in dem Beschichtungsrad nicht beschichtet wird. Hierbei ist zu beachten, dass jedem Behälter innerhalb einer Beschichtungseinheit ein eigener Mikrowellengenerator zugeordnet ist. Entsprechend ist es möglich den Betrieb der Mikrowellengeneratoren einzeln zu steuern. Somit wird in dem bereits beschichteten Behälter zwar ein Vakuum erzeugt. Allerdings wird ein weiterer Beschichtungsprozess vermieden. Somit ist es nicht erforderlich, einen doppelt beschichteten Behälter auszusortieren.

Eine solche Verfahrensführung kann grundsätzlich in zwei verschiedenen Art und Weisen erfolgen. Gemäß einer ersten Variante verbleiben die bereits beschichteten Behälter in den Beschichtungseinheiten an den Positionen, welche die unbesetzte Position innerhalb der Behälterreihe definieren. Entsprechend werden also einzelne beschichtete Behälter nicht aus dem Beschichtungsrad entnommen. Allerdings setzt dies voraus, dass die Entnahme der Behälter direkt gesteuert werden kann. Gerade bei bereits in der Produktion eingesetzten Beschichtungsanlagen erfolgt jedoch das Ausbleiten der Behälter aus dem Beschichtungsrad in einer passiven Art und Weise. Entsprechend werden die Behälter zwangsgeführt aus dem Beschichtungsrad geleitet, sodass eine Steuerung der Entnahme nicht unmittelbar realisiert werden kann. Darüber hinaus kann es auch problematisch sein, dass die noch im Beschichtungsrad angeordneten beschichteten Behälter eine zu hohe Temperatur aufgrund des Beschichtungsprozesses aufweisen, sodass ein erneuter Beschichtungsprozess unmittelbar im Anschluss nicht ohne Weiteres realisiert werden kann.

Gemäß einer bevorzugten zweiten Alternative ist daher vorgesehen, dass über eine zwischen der Einlauf- und der Auslaufsternanordnung angeordnete Bypassradanordnung zumindest ein beschichteter Behälter aus der Auslaufsternanordnung abgeführt und der Einlaufsternanordnung jeweils an der unbesetzten Position zugeführt wird. Solche Bypassradanordnungen sind beispielsweise aus der EP 3 281 768 B1 oder der DE 10 2023 108 306 A1 bekannt und dienen dazu, die Behälter ohne Zwischenschaltung des Beschichtungsrades an weitere Anlagenkomponenten zu übergeben. Dies kann insbesondere dann sinnvoll sein, wenn eine Behälterfüllanlage in verschiedenen Art und Weisen betrieben werden soll. So ist es beispielsweise denkbar, dass für einzelne Produktionschargen eine Beschichtung nicht erforderlich ist, sodass entsprechend ohne dem Vorsehen einer Bypassradanordnung zwingend sämtliche Behälter durch das Beschichtungsrad geführt werden müssten, wodurch die Produktion in unnötiger Art und Weise verlangsamt würde. Durch Einbinden einer Bypassradanordnung kann dann das Beschichtungsrad umgangen werden. Entsprechend ist das Beschichtungsrad im Normalbetrieb dazu vorgesehen, unbeschichtete Behälter von der Einlaufsternanordnung an die Auslaufsternanordnung zu übergeben.

Die Erfindung macht sich nunmehr den Umstand zunutze, dass das Vorsehen einer Bypassradanordnung nunmehr auch dazu genutzt werden kann, um bereits beschichtete Behälter aus der Auslaufsternanordnung an die Einlaufsternanordnung zu übergeben, sodass die unbesetzte Position in der Behälterreihe aufgefüllt und der Beschichtungsprozess fortgesetzt werden kann. Entgegen der DE 10 2023 183 061 A1 wird daher die Bypassradanordnung auch im Produktionsbetrieb nicht aus der Beschichtungsanlage herausgenommen, sondern vielmehr in umgekehrter Art und Weise betrieben, als dies bei einem Betrieb unter Umgehung des Beschichtungsrades erforderlich ist.

Besonders bevorzugt ist das erfindungsgemäße Verfahren, wenn zumindest drei, bevorzugt zumindest vier Behälter während einer Rotation des Beschichtungsrades gemeinsam in einer Beschichtungseinheit beschichtet werden. In einem solchen Falle hätte eine unbesetzte Position innerhalb der Beschichtungseinheit zur Folge, dass zumindest zwei bzw. zumindest drei innerhalb der Beschichtungseinheit angeordnete Behälter aufgrund des Abschaltens der kompletten Beschichtungseinheiten nicht beschichtet werden könnten. Entsprechend müssen zwei bzw. drei Behälter aus der Auslaufsternanordnung abgeführt werden. Durch Hinzuführen eines beschichteten Behälters in die Beschichtungseinheit ist es nunmehr möglich, den Beschichtungsprozess zu starten, sodass lediglich der doppelt beschichtete Behälter anschließend abgeführt werden muss. Hierdurch wird der Anteil der aussortierten Behälter deutlich reduziert.

Gemäß einer Weiterbildung der Erfindung weist ist die Bypassradanordnung zumindest ein Bypassrad mit einer Vielzahl von Behälteraufnahmen auf, wobei vor und/oder zu Beginn des Produktionsbetriebes zumindest einem Teil der Behälteraufnahmen beschichtete Behälter zugeführt werden. Gemäß einer solchen Ausgestaltung wird der Ausleitprozess aus der Auslaufsternanordnung ein Stück weit von der Einführung in die unbesetzte Position entkoppelt. So können die Behälteraufnahmen innerhalb des Bypassrades als eine Art Puffer genutzt werden, um gezielt ein Einführen beschichteter Behälter in die Einlaufsternanordnung einzuleiten. Eine solche Ausgestaltung hat den Vorteil, dass die Bypassradanordnung bzw. das Bypassrad synchron zu der Einlaufsternanordnung und der Auslaufsternanordnung betrieben werden kann, sofern sämtliche Behälteraufnahmen innerhalb des Bypassrades besetzt sind. Entsprechend kann nach Erfassen der unbesetzten Positionen gezielt ein beschichteter Behälter aus der Bypassradanordnung zugeführt werden. Hierbei wird dann die Behälteraufnahme innerhalb des Bypassrades der Bypassradanordnung ermittelt, welche infolge der Rotation unmittelbar an die unbesetzte Position in der Einlaufsternanordnung angrenzt. Ausgehend von dieser Behälteraufnahme kann dann der beschichtete Behälter an die Einlaufsternanordnung übergeben werden.

Ausgehend von einer solchen Ausgestaltung kann mit Beginn des Produktionsbetriebes zunächst dass zumindest eine Bypassrad aufgefüllt und erst dann der eigentliche Produktionsbetrieb gestartet werden. Sofern einzelne Behälteraufnahmen der Bypassradanordnung geleert werden, können diese dann im laufenden Produktionsbetrieb erneut aufgefüllt werden.

Alternativ ist es aber auch denkbar, dass das zumindest eine Bypassrad der Bypassradanordnung nicht als Puffer verwendet wird. Gemäß einer solchen Ausgestaltung wird auf Basis der erfassten Position ein beschichteter Behälter aus der Auslaufsternanordnung abgeführt. Bei einem synchronen Betrieb der Bypassradanordnung mit der Einlaufsternanordnung und der Auslaufsternanordnung wird entsprechend nach Ermittlung der unbesetzten Position bestimmt, an welcher Positionen der Behälterreihe der beschichtete Behälter abgeführt werden muss, damit dieser infolge der Bewegung des Bypassrades an die unbesetzte Position in der Einlaufsternanordnung weitergeleitet werden kann.

Grundsätzlich ist es auch denkbar, dass die Bypassradanordnung bzw. das zumindest eine Bypassrad nicht synchron zu der Einlaufsternanordnung und der Auslaufsternanordnung betrieben wird. In diesem Fall weist die Bypassradanordnung eine separate Antriebseinrichtung auf, welche die Bewegung der Bypassradanordnung unabhängig von den anderen Anlagenkomponenten steuert. Nach Erfassen einer unbesetzten Position kann dann das Bypassrad gezielt beschleunigt werden, um einen Behälter von der Auslaufsternanordnung an die Einlaufsternanordnung übergeben zu können.

Eine Weiterbildung der Erfindung sieht ferner vor, dass der an der unbesetzten Position zugeführte beschichtete Behälter vor der erneuten Zuführung in das Beschichtungsrad eine Behältertemperatur von maximal 30 °C, insbesondere von maximal 28 °C, aufweisen. Hierbei ist zu beachten, dass die Behälter bei der Zuführung in das Beschichtungsrad einen vorbestimmten Wert für die Behältertemperatur nicht überschreiten dürfen, da ansonsten das Material der Behälter zu weich für einen Beschichtungsprozesses ist. Ein zu weiches Material hätte hierbei zur Folge, dass die Behälter aufweichen und den Vakuumdruck innerhalb des Behälterinnenraumes nicht standhalten können. In diesem Fall würde bei Beschädigung der Behälterwandung auch das Vakuum in der gesamten Beschichtungseinheit nicht aufrechterhalten werden können, sodass in diesem Fall die Beschichtung an allen Positionen der Beschichtungseinheit versagen würde. Vor diesem Hintergrund ist sicherzustellen, dass die Transportstrecke zwischen über die Bypassradanordnung so groß bemessen ist, dass innerhalb dieses Zeitraumes für die Bewegung an die unbesetzte Position, der Behälter soweit abkühlen kann, dass dieser den Wert von 30 °C bzw. 28 °C nicht überschreitet.

Sofern allein aufgrund der konstruktiven Ausgestaltungen nicht sichergestellt werden kann, dass die maximale Temperatur nicht erreicht wird, so kann es auch zweckmäßig sein, dass der beschichtete Behälter vor der Zuführung in das Beschichtungsrad, insbesondere vor der Zuführung in die Einlaufsternanordnung, aktiv gekühlt wird.

Gegenstand der Erfindung ist ferner eine Beschichtungsanlage zum Beschichten von Behältern, insbesondere von Getränkebehältern, mit einem eine Vielzahl von Beschichtungseinheiten aufweisenden Beschichtungsrad, wobei die Beschichtungseinheiten dazu eingerichtet sind, jeweils zumindest zwei Behälter während einer Rotation des Beschichtungsrades gemeinsam zu Beschichten und wobei unbeschichtete Behälter über eine Einlaufsternanordnung dem Beschichtungsrad zugeführt und beschichtete Behälter über die Auslaufsternanordnung abgeführt werden. Erfindungsgemäß ist vorgesehen, dass eine Sensoreinrichtung zur Erfassung von unbesetzten Positionen in der Einlaufanordnung vorgesehen ist und wobei eine Steuerungseinrichtung auf Basis der ermittelten unbesetzten Positionen zur Durchführung des erfindungsgemäßen Verfahrens eingerichtet ist.

Gemäß der bevorzugten Ausgestaltung ist eine Bypassradanordnung dazu eingerichtet, Behälter zwischen der Auslaufsternanordnung und der Einlaufsternanordnung zu transportieren. Entsprechend erfolgt eine Überführung beschichteter Behälter aus der Auslaufsternanordnung an die Einlaufsternanordnung. Bevorzugt erfolgt dies auf Basis der von der Sensoreinrichtung erfassten unbesetzten Positionen. Folglich ist die Bypassradanordnung mit der Steuerungseinrichtung verbunden, wobei die Steuerungseinrichtung dazu eingerichtet ist, die Übergabe der Behälter zwischen der Auslaufsternanordnung und der Einlaufsternanordnung zu steuern.

Ausgehend hiervon kann die Bypassradanordnung zumindest ein Bypassrad mit einer Vielzahl von Behälteraufnahmen aufweisen, wobei die Behälteraufnahmen als aktive Greifer ausgebildet sind. In diesem Fall erfolgt die Übergabe der Behälter über die aktiven Greifer, wobei die Sensoreinrichtung derart mit der Bypassradanordnung in Verbindung steht, dass über ein Ansteuern der aktiven Greifer eine Entnahme aus der Auslaufsternanordnung und eine Übergabe an die Einlaufsternanordnung ermöglicht wird. Die aktiven Greifer stehen dann jeweils bevorzugt mit einem Antriebselement in Verbindung, welches die Bewegung der aktiven Greifer steuert und wobei dieses Antriebselement eine Signalübertragung mit der Steuerungseinrichtung ermöglicht.

Gemäß einer bevorzugten Weiterbildung der Erfindung weist die Sensoreinrichtung zumindest eine vor und/oder an der Einlaufsternanordnung angeordnete Lichtschranke auf. Anhand dieser Lichtschranke ist es möglich zu ermitteln, ob einzelne Positionen innerhalb einer Behälterreihe nicht besetzt sind. Im Falle einer solchen Detektion kann dann die Sensoreinrichtung ein Signal an die Steuerungseinrichtung übergeben, wobei die Steuerungseinrichtung auf Basis der erfassten Daten eine Bewegung der aktiven Greifer derart steuert, dass an gezielten Positionen ein beschichteter Behälter aus der Auslaufsternanordnung entnommen und/oder an die unbesetzte Position in der Einlaufsternanordnung übergeben wird.

Gemäß einer bevorzugten Weiterbildung der Erfindung ist eine Kühleinrichtung zum Kühlen zumindest eines Teils der beschichteten Behälter vorgesehen. Diese kann insbesondere im Bereich des Bypassrades angeordnet sein und sicherstellen, dass die aus der Auslaufsternanordnung entnommenen beschichteten Behälter soweit heruntergekühlt werden, dass sie beim Einführen in das Beschichtungsrad eine Temperatur von maximal 30 °C, insbesondere von maximal 28 °C, nicht überschreiten. Selbstverständlich ist es auch denkbar, die Kühleinrichtung im Bereich der Einlaufsternanordnung vorzusehen, wobei dann generell sichergestellt wird, dass sämtliche an das Beschichtungsrad übergebene Behälter die zuvor beschriebene maximale Temperatur nicht überschreiten.

Gemäß der bevorzugten Ausgestaltung der Erfindung sind die Beschichtungseinheiten dazu eingerichtet, jeweils zumindest drei Behälter, besonders bevorzugt zumindest vier Behälter während einer Rotation des Beschichtungsrades gemeinsam zu beschichten. Entsprechend weisen die Beschichtungseinheiten zumindest drei oder zumindest vier Behälteraufnahmen auf. Nach Einführen der Behälter in die Behälteraufnahmen wird eine Beschichtungskammer geschlossen, um zum einen in den Behältern ein Vakuuminnendruck und zugleich auch ein Vakuumaußendruck zu erzeugen, sodass in dem Vakuums gezielt der Beschichtungsprozess zum Innenbeschichten der Behälter eingeleitet werden kann.

Die Beschichtungseinheiten können darüber hinaus zum Beschichten der Behälter jeweils einen einer Behälteraufnahme zugeordneten Mikrowellengenerator aufweisen. Diese Steuerungseinrichtung sind mit der Steuerungseinrichtung verbunden, wobei die Steuerungseinrichtung dazu eingerichtet sein kann, ausschließlich die Mikrowellengeneratoren zu betreiben, welche jeweils einer Behälteraufnahme mit einem unbeschichteten Behälter zugeordnet sind. Entsprechend werden Steuerungseinrichtung, welche jeweils einer Behälteraufnahme mit einem beschichteten Behälter zugeordnet sind, nicht betrieben.

Nach Abschluss des Beschichtungsprozesses wird das Vakuum sowohl im Behälterinnenraum als auch innerhalb der Beschichtungskammer heruntergefahren und die Beschichtungskammer geöffnet. Sodann kann dann über die Auslaufsternanordnung ein Ausführen der Behälter aus dem Beschichtungsrad ermöglicht werden.

Im Folgenden wird die Erfindung anhand von Zeichnungen exemplarisch erläutert. Es zeigen:
- Fig. 1: eine schematische Darstellung einer Beschichtungsanlage während des Produktionsbetriebes,
- Fig. 2 bis 4: eine schematische Darstellung des erfindungsgemäßen Verfahrens zum Auffüllen von Lücken in der Behälterreihe.

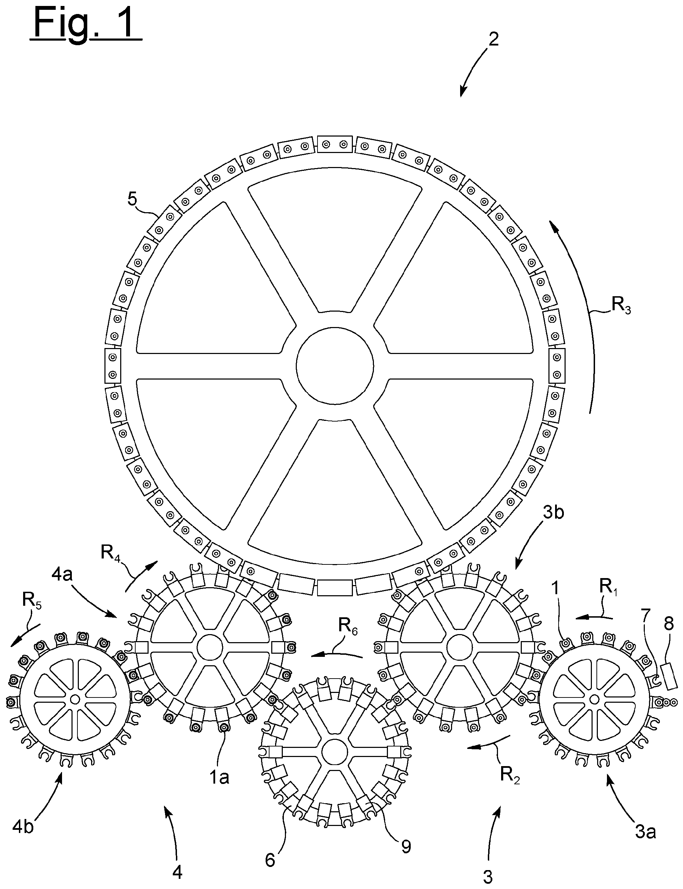

Die Fig. 1 zeigt eine Beschichtungsanlage zum Beschichten von Behältern 1 in Form von Getränkeflaschen aus Polyethylenterephthalat, die in einer geschlossenen Behälterreihe entlang eines Transportpfades geführt werden und wobei sich der Transportpfad im Wesentlichen anhand der Rotation eines Beschichtungsrad 2, einer vorgeordneten Einlaufsternanordnung 3 sowie einer nachgeordneten Einlaufsternanordnung 4 ergibt. Die Rotation der einzelnen Anlagenkomponenten ist in der Fig. 1 gezeigt, wobei der Transportpfad durch die Einzelrotationen R₁, R₂, R₃, R₄ und R₅ definiert wird.

Die Einlaufsternanordnung 3 besteht aus zwei Transportsternen 3a, 3b, wobei der Transportstern 3b unmittelbar an das Beschichtungsrad 2 angrenzt und darüber hinaus als Wendestern ausgebildet sein kann, welcher die Behälter 1 von einer aufrechtstehenden in eine kopfüberstehende Position überführt. In dieser Position werden die Behälter 1 dann in das Beschichtungsrad 2 eingeführt.

Das Beschichtungsrad 2 besteht wiederum aus einer Vielzahl von Beschichtungseinheiten 5, welche dazu eingerichtet sind jeweils zwei Behälter 1 während einer Rotation des Beschichtungsrades 2 gemeinsam zu beschichten. Hierzu werden die Behälter 1 innerhalb einer gemeinsamen Beschichtungskammer angeordnet und sowohl im Behälterinnenraum als auch in der Beschichtungskammer selbst ein Vakuum erzeugt, welches allerdings nur dann aufrechterhalten werden kann, wenn die Behälter 1 dichtend in der Beschichtungseinheit 5 an allen Behälterpositionen eingesetzt sind. Insofern ist es entscheidend für den Beschichtungsprozess, dass beide Positionen innerhalb der geschlossenen Behälterreihe in einer Beschichtungseinheit 5 besetzt sind. Sofern eine Position nicht besetzt ist, hat das zur Folge, dass der Beschichtungsprozess innerhalb der jeweiligen Beschichtungseinheit 5 nicht gestartet werden kann, sodass in der Beschichtungseinheit 5 eingesetzte Behälter 1 unbeschichtet aus dem Beschichtungsrad 2 ausgeführt werden. Dies ist insbesondere dann problematisch, wenn nicht nur zwei Behälter 1 gemeinsam innerhalb einer Beschichtungseinheit 5 beschichtet werden sondern drei, vier oder gar mehr Behälter 1.

Die beschichteten Behälter 1a werden sodann über die Auslaufsternanordnung 4 in einen unmittelbar an das Beschichtungsrad 2 angrenzenden Transportstern 4a sowie ein daran anschließenden Transportstern 4b ausgeleitet. Auch hier kann der unmittelbar an das Beschichtungsrad 2 angrenzende Transferstern 4a als Wendestern ausgebildet sein, um die beschichteten Behälter 1a erneut in eine aufrechtstehende Position überführen zu können.

Darüber hinaus ist zwischen den unmittelbar an das Beschichtungsrad 2 angrenzenden Transfersternen 3b und 4a ein Bypassrad 6 einer Bypassradanordnung angeordnet, welches in der Richtung R₆ rotiert und dazu vorgesehen ist, Behälter 1 zwischen der Einlaufsternanordnung 3 und der Auslaufsternanordnung 4 unter Umgehung des Bypassrades 2 zu bewegen.

Erfindungsgemäß wird dieses Bypassrad 6 nunmehr dazu verwendet, um eine unbesetzte Position 7 in der geschlossenen Behälterreihe aufzufüllen, um so einen kontinuierlichen Beschichtungsprozess in sämtlichen Beschichtungseinheiten 5 ermöglichen zu können. Hierzu wird die unbesetzte Position 7 von einer Sensoreinrichtung 8 erfasst und ein Signal an eine nicht näher dargestellte Steuerungseinrichtung übermittelt.

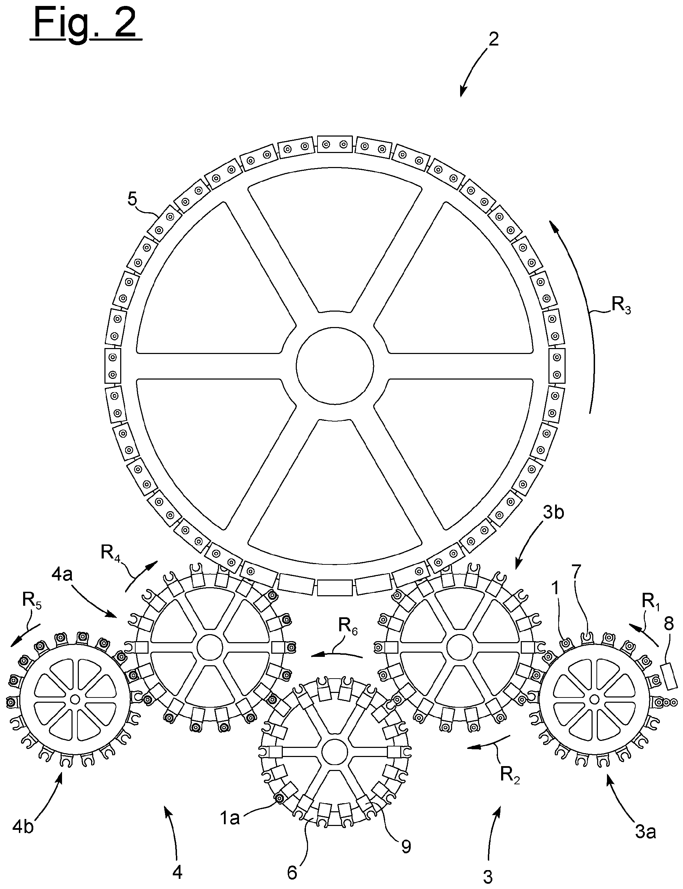

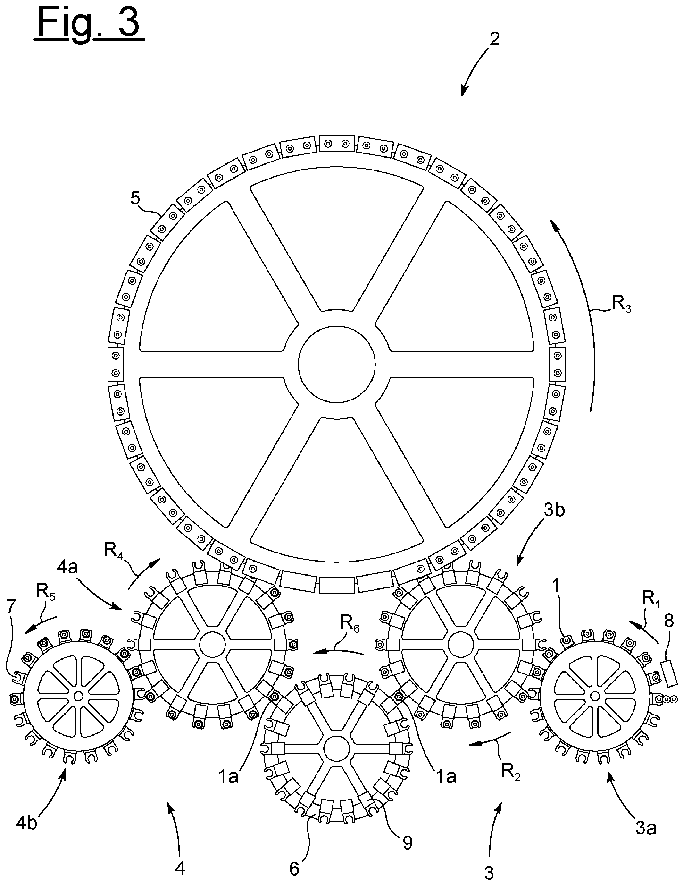

Die Steuerungseinrichtung leitet einen Prozess ein, bei dem ein beschichteter Behälter 1a aus der Auslaufsternanordnung 4a in das Bypassrad 6 überführt wird. Auch die unbesetzte Position 7 rotiert gemäß der Fig. 2 weiter, wobei die Positionen zwischen dem von dem Bypassrad 6 aufgenommenen beschichteten Behälter 1a und der unbesetzten Position 7 derart zueinander abgestimmt sind, dass diese gemäß der Fig. 3 an der Übergabeposition zwischen dem Bypassrad 6 und der Einlaufsternanordnung 3 bzw. dem Transferstern 3b unmittelbar aneinander angrenzen und eine Übergabe des beschichteten Behälters 1a an den Transferstern 3b erfolgen kann.

Sodann erfolgt die Übergabe an das Beschichtungsrad 2 und der bereits beschichtete Behälter 1a wird erneut innerhalb des Beschichtungsrades 2 beschichtet. Da aus lebensmitteltechnischen Gründen eine doppelte Beschichtung in der Regel nicht zulässig ist, erfolgt im Anschluss ein Abführen dieses Behälters 1a. Dennoch kann eine solche Verfahrensführung besonders dann zweckmäßig sein, wenn drei, vier oder sogar mehr Behälter 1 innerhalb einer Beschichtungseinheit 5 beschichtet werden, sodass der Verlust eines einzelnen beschichteten Behälters 1a von Vorteil ist. Bei der erneuten Zuführung in das Beschichtungsrad 2 ist zu beachten, dass der bereits beschichtete Behälter 1a eine Temperatur von maximal 30 °C, insbesondere 28 °C, nicht überschreitet, um einen störungsfreien Beschichtungsbetrieb zu ermöglichen. Hierzu kann es auch zweckmäßig sein, eine nicht näher dargestellte Kühleinrichtung vorzusehen, welche den bereits beschichteten Behälter 1a auf eine angemessene Temperatur herunterkühlt.

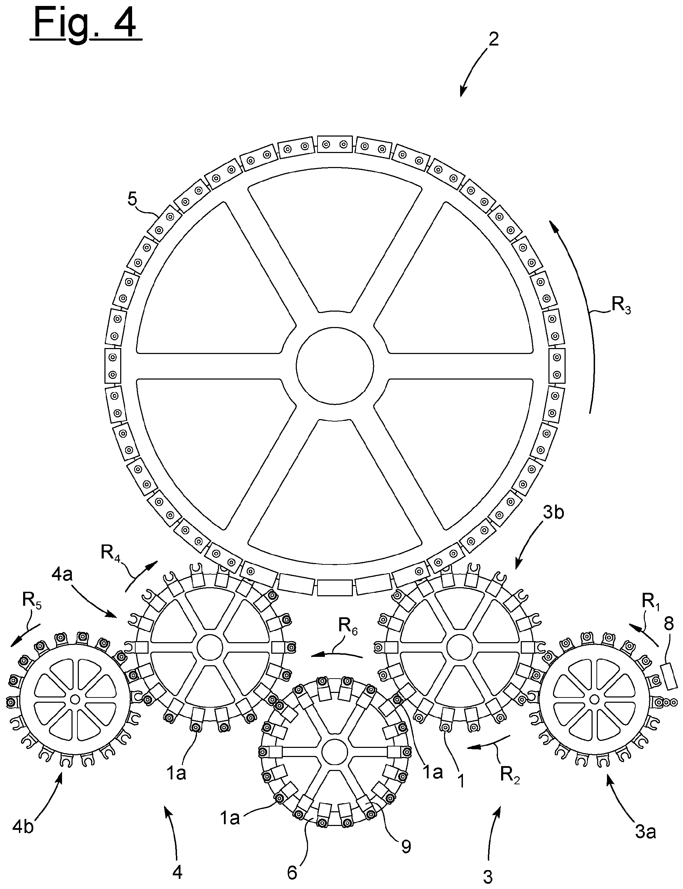

Fig. 4 zeigt eine alternative Ausgestaltung des Prozesses, bei dem das Beschichtungsrad 6 mit beschichteten Behältern 1a aufgefüllt ist. Entsprechend wird der Ausleitprozess des beschichteten Behälters 1a aus dem Transferstern 4a nicht in Abhängigkeit einer detektierten unbesetzten Position 7 gesteuert, da bereits ausreichend beschichtete Behälter 1a in dem Beschichtungsrad 6 angeordnet sind, welches als eine Art Puffer dienen.

Sodann erfolgt eine Übergabe eines beschichteten Behälters 1a an den Transferstern 3b, sodass hierdurch die unbesetzte Position 7 aufgefüllt werden kann. Anhand der Fig. 4 wird auch deutlich, dass das Bypassrad 6 Behälteraufnahmen 9 in Form von aktiven Greifern aufweist, welche separat voneinander angesteuert die Übergabe zwischen der Einlaufsternanordnung 3 bzw. den Transferrad 3b und der Auslaufsternanordnung 4 bzw. dem Transferstern 4b ermöglichen. Auch bei der Verfahrensführung gemäß den Figuren 2 und 3 sind solche aktiven Greifer vorgesehen aber nicht näher dargestellt.

### Bezugszeichenliste

- 1: Behälter
- 1a: beschichtete Behälter
- 2: Beschichtungsrad
- 3: Einlaufsternanordnung
- 3a, 3b: Transportsterne der Einlaufsternanordnung
- 4: Auslaufsternanordnung
- 4a, 4b: Transportsterne der Auslaufsternanordnung
- 5: Beschichtungseinheit
- 6: Bypassrad
- 7: unbesetzte Position
- 8: Sensoreinrichtung
- 9: Behälteraufnahme

- R1 - R5: Rotationsrichtung der einzelnen Anlagenkomponenten

## Patentansprüche

1. Verfahren zum Beschichten von Behältern (1), insbesondere von Getränkebehältern, aus Kunststoff, wobei die Behälter (1) in einem Sollzustand in einer geschlossenen Behälterreihe entlang eines Transportpfades während dem Produktionsbetrieb einem Beschichtungsrad (2) über eine Einlaufsternanordnung (3) zugeführt und anschließend zumindest zwei Behälter (1) während einer Rotation des Beschichtungsrades (2) gemeinsam in einer Beschichtungseinheit (5) beschichtet werden und wobei die beschichteten Behälter (1a) über eine Auslaufsternanordnung (4) abgeführt werden,
**dadurch gekennzeichnet, dass**
zumindest eine unbesetzte Position (7) in der Behälterreihe vor und/oder in der Einlaufsternanordnung (3) erfasst wird und wobei jeweils ein beschichteter Behälter (1a) an der unbesetzten Position (7) zugeführt wird.

2. Verfahren nach Anspruch 1, **dadurch gekennzeichnet, dass** über eine zwischen der Einlauf- und der Auslaufsternanordnung (3, 4) angeordnete Bypassradanordnung zumindest ein beschichteter Behälter (1a) aus der Auslaufsternanordnung (4) abgeführt und der Einlaufsternanordnung (3) an der unbesetzten Position (7) zugeführt wird.

3. Verfahren nach einem der vorangegangenen Ansprüche, **dadurch gekennzeichnet, dass** zumindest drei, bevorzugt zumindest vier, Behälter (1) während einer Rotation des Beschichtungsrades (2) gemeinsam in einer Beschichtungseinheit (5) beschichtet werden.

4. Verfahren nach einem der vorangegangenen Ansprüche, **dadurch gekennzeichnet, dass** die Bypassradanordnung zumindest ein Bypassrad (6) mit einer Vielzahl von Behälteraufnahmen (9) aufweist, wobei vor und/oder zu Beginn des Produktionsbetriebes zumindest einem Teil der Behälteraufnahmen (9) beschichtete Behälter (1a) zugeführt werden.

5. Verfahren nach einem der vorangegangenen Ansprüche, **dadurch gekennzeichnet, dass** auf Basis der erfassten Position ein beschichteter Behälter (1a) aus der Bypassradanordnung zugeführt wird.

6. Verfahren nach Anspruch 4 oder 5, **dadurch gekennzeichnet, dass** auf Basis der erfassten Position ein beschichteter Behälter (1a) aus der Auslaufsternanordnung (4) abgeführt wird.

7. Verfahren nach Anspruch 6, **dadurch gekennzeichnet, dass** der abgeführte beschichtete Behälter (1a) unmittelbar an der erfassten Position zugeführt wird.

8. Verfahren nach einem der vorangegangenen Ansprüche, **dadurch gekennzeichnet, dass** der an der unbesetzten Position (7) zugeführte beschichtete Behälter (1a) vor der erneuten Zuführung in das Beschichtungsrad (2) eine Behältertemperatur von maximal 30 °C aufweist.

9. Verfahren nach Anspruch 8, **dadurch gekennzeichnet, dass** der beschichtete Behälter (1a) vor der Zuführung in das Beschichtungsrad (2), insbesondere vor der Zuführung in die Einlaufsternanordnung (3), gekühlt wird.

10. Beschichtungsanlage zum Beschichten von Behältern (1), insbesondere von Getränkebehältern, mit einem eine Vielzahl von Beschichtungseinheiten (5) aufweisenden Beschichtungsrad (2), wobei die Beschichtungseinheiten (5) dazu eingerichtet sind, jeweils zumindest zwei Behälter (1) während einer Rotation des Beschichtungsrades (2) gemeinsam zu beschichten und wobei unbeschichtete Behälter über eine Einlaufsternanordnung (3) dem Beschichtungsrad (2) zugeführt und beschichtete Behälter (1a) über die Auslaufsternanordnung (4) abgeführt werden,
**dadurch gekennzeichnet, dass**
eine Sensoreinrichtung (8) zur Erfassung von unbesetzten Positionen (7) in der Einlaufanordnung vorgesehen ist und wobei eine Steuerungseinrichtung auf Basis der ermittelten unbesetzten Positionen zur Durchführung des Verfahrens nach einem der vorangegangenen Ansprüche eingerichtet ist.

11. Beschichtungsanlage nach Anspruch 10, **dadurch gekennzeichnet, dass** eine Bypassradanordnung dazu eingerichtet ist, Behälter (1) unter Umgehung des Beschichtungsrades (2) zwischen der Auslaufsternanordnung (4) und der Einlaufsternanordnung (3) zu transportieren.

12. Beschichtungsanlage nach Anspruch 11, **dadurch gekennzeichnet, dass** die Bypassradanordnung zumindest eine Bypassrad (6) mit einer Vielzahl von Behälteraufnahmen (9) aufweist, wobei die Behälteraufnahmen (9) als aktive Greifer ausgebildet sind.

13. Beschichtungsanlage nach einem der Ansprüche 10 bis 12, **dadurch gekennzeichnet, dass** die Sensoreinrichtung (8) zumindest eine vor und/oder an der Einlaufsternanordnung (3) angeordnete Lichtschranke aufweist.

14. Beschichtungsanlage nach einem der Ansprüche 10 bis 13, **dadurch gekennzeichnet, dass** eine Kühleinrichtung zum Kühlen zumindest eines Teils der beschichteten Behälter (1a) vorgesehen ist.

15. Beschichtungsanlage nach einem der Ansprüche 10 bis 14, **dadurch gekennzeichnet, dass** die Beschichtungseinheiten (5) dazu eingerichtet sind, jeweils zumindest drei Behälter (1) während einer Rotation des Beschichtungsrades (2) gemeinsam zu beschichten.
